Europäisches Patentamt

European Patent Office

Office européen des brevets

(11) Veröffentlichungsnummer: **0 193 490**
A1

## (12) EUROPÄISCHE PATENTANMELDUNG

(21) Anmeldenummer: 86730023.8

(22) Anmeldetag: 17.02.86

(51) Int. Cl.⁴: **H01R 43/01** , H01R 4/24 , H05K 13/06

(30) Priorität: 22.02.85 DE 3506797

(43) Veröffentlichungstag der Anmeldung:
03.09.86 Patentblatt 86/36

(84) Benannte Vertragsstaaten:
DE FR IT

(71) Anmelder: Siemens Aktiengesellschaft Berlin und München
Wittelsbacherplatz 2
D-8000 München 2(DE)

(72) Erfinder: Gottschalk, Walter
Michelstadter Weg 61
D-1000 Berlin 20(DE)

(54) Verfahren zur Verlegung von elektrischen Leitern in einem Verdrahtungsfeld.

(57) Anschlußelemente des Verdrahtungsfeldes werden als Schneidklemmen (S) mit einem Klemmbereich (KB) und einem darunter gelegenen Schneidklemmbereich (SB) ausgebildet. Die Drähte (D) werden zunächst mit ihrer Isolation (I) in den Klemmbereichen (KB) klemmend festgelegt und erst nach Verlegung des ganzen Drahtabschnitts bzw. aller Drähte (D) innerhalb des Verdrahtungsfeldes gleichzeitig in die Schneidklemmbereiche (SB) des Verdrahtungsfeldes überführt.

FIG. 2

EP 0 193 490 A1

Verfahren zur Verlegung von elektrischen Leitern in einem Verdrahtungsfeld

Die Erfindung betrifft ein Verfahren zur Verlegung von Drähten in einem Verdrahtungsfeld mit galvanisch mit Anschlußpunkten elektrischer Schaltungsanordnungen verbundenen Anschlußelementen zum lötfreien Anschluß der beliebige Anschlußelemente miteinander verbindenden Drähte mittels eines Verdrahtungswerkzeugs.

Derartige Verdrahtungsfelder werden z. B. in elektrischen Geräten eingesetzt, deren elektrischen Schaltungsanordnungen durch unterschiedliche Verbindung bestimmter Anschlußpunkte unterschiedliche Funktionen zugewiesen werden können. Derartige Anordnungen sind z. B. bei elektrischen Konsumgütergeräten anzutreffen, die durch unterschiedliche Ergänzungen eines Basisgeräts unterschiedliche Bautypen bilden.

Als Anschlußelemente zum lötfreien Anschluß von Drähten sind bisher im Zusammenhang mit derartigen Verdrahtungsfeldern sogenannte Wire-Wrap-Anschlußstifte bekannt. Das Verdrahten derartiger Verdrahtungsfelder in der Wire-Wrap-Technik ist verhältnismäßig zeitaufwendig; dies gilt insbesondere dann, wenn mehrfach jeweils mehrere Anschlußelemente untereinander galvanisch zu verbinden sind, da es mit der Wire-Wrap-Technik nicht möglich ist, aus Leitern mit Isolation bestehende Leitungszüge über mehrere Anschlüsse durchzuschleifen.

Die der Erfindung zugrunde liegende Aufgabe besteht darin, das bekannte Verfahren zur Verlegung von Drähten in einem Verdrahtungsfeld derart zu modifizieren, daß eine - schnellere Verlegung und insbesondere das Durchschleifen von Leitungszügen über mehrere Anschlußelemente möglich wird. Dies wird erfindungsgemäß dadurch erreicht, daß die Anschlußelemente als Schneidklemmen mit einem sich an einen Einführungsbereich anschließenden Klemmbereich ausgebildet sind, in dem die als Leiter mit Isolation ausgebildeten Drähte zunächst klemmend festgelegt werden, und einem an den Klemmbereich anschließenden Schneidklemmbereich, in den die Drähte nach beendeter Verlegung eingedrückt werden.

Ein wesentlicher Schritt des erfindungsgemäßen Verfahrens ist darin zu sehen, daß von der Wire-Wrap-Technik abgegangen und statt dessen ein im wesentlichen aus Schneidklemmen gebildetes Verdrahtungsfeld eingesetzt wird. Derartige Schneidklemmen sind an sich als Anschlußelemente zum lötfreien Anschluß von Drähten bisher in der Praxis aber auf die Konfektionierung von Kabeln bzw. auf die Festlegung von Ein-und Ausgängen von Schaltungsanordnungen an Anschlußleisten mit mehreren solchen Schneidklemmen nebeneinander beschränkt geblieben.

Der Grund hierfür ist darin zu sehen, daß jeweils der den eigentlichen Leiter kontaktierende Bereich als kritisches Element jedes isolationsdurchdringenden Verbindungssystems anzusehen ist. Insbesondere die Anforderung, daß eine dauerhaft gasdichte Verbindung mit möglichst geringem Übergangswiderstand geschaffen werden soll, der unabhängig von allen äußeren Umgebungseinflüssen nahezu konstant bleibt, wäre im Rahmen eines Verdrahtungsfeldes nicht ohne weiteres zu erfüllen. Nach Festlegen eines Drahtes in einer Schneidklemme führten nämlich zwangsläufig die weiteren Verlegungsvorgänge sowie das nachfolgende Eindrücken der Drähte in andere Schneidklemmen zur Ausübung von Kräften auf den Ort der zunächst gasdichten Verbindung von Leiter und Schneidklemme. Störungen bzw. eine totale Aufhebung der Kontaktierung wären dabei nicht mit Sicherheit zu vermeiden. Diese Gefahr der Verschlechterung bzw. völligen Aufhebung der Kontaktierung wird im Rahmen des erfindungsgemäßen Verfahrens dadurch vermieden, daß die Schneidklemmen eine ganz bestimmte Form erhalten und die Arbeitsweise des Verdrahtungswerkzeugs darauf abgestimmt wird. Die Drähte werden zunächst in den Klemmbereich eingeführt, in dem noch kein Durchschneiden der Isolation, sondern lediglich eine Quetschung derselben stattfindet; in dieser Lage der Drähte wird die Verlegung weitergeführt und erst in einer Phase, in der keine Kräfte mehr auf den geklemmten Draht ausgeübt werden, das eigentliche Eindrücken der Drähte vorgenommen.

Dieses Eindrücken kann beispielsweise derart geschehen, daß die Drähte mittels des Verdrahtungswerkzeuges sukzessiv in die Schneidklemmbereiche eingedrückt werden. Dies kann beispielsweise jeweils nach der Verlegung eines Drahtzuges erfolgen, wodurch die Verlegung anderer Drähte in den gleichen zwischen den Schneidklemmen gebildeten Verlegegassen erleichtert wird. Als vorteilhafter ist jedoch anzusehen, erst nach der Verlegung aller Drähte im Verdrahtungsfeld das sukzessive Eindrücken in die Schneidklemmbereiche zu beginnen, sofern -wie eine vorteilhafte Weiterbildung der Erfindung vorsieht -die Drähte in derselben Reihenfolge in die Schneidklemmbereiche eingedrückt werden, in der sie in die Klemmbereiche verlegt sind. Bei Einhaltung dieser Reihenfolge wird jede störende Beeinflussung von bereits fertiggestellten Kontaktierungen in den Schneidklemmbereichen vermieden.

Ebenso ist es möglich, daß die Drähte mittels eines zumindest eine Vielzahl von Schneidklemmen gleichzeitig erfassenden Werkzeugs in die Schneidklemmbereiche eingedrückt werden. Bei Anwendung dieser Verfahrensvariante wird die Gesamtzeit zur Fertigstellung der Verdrahtung weiter verringert. Dieses Verfahren bietet zugleich den Vorteil, daß ein großer Teil der Drähte, vorzugsweise alle Drähte gleichzeitig in die eigentlichen Schneidklemmbereiche eingedrückt werden, so daß auch die geringsten nachfolgenden mechanischen Beanspruchungen der gasdichten Kontaktstellen vermieden sind.

Dieses Prinzip der gleichzeitigen Eindrückung aller geklemmten Drähte in die jeweils zugeordneten Schneidklemmbereiche der Schneidklemmen kann auch in der Weise erfolgen, daß allen Schneidklemmen eine gemeinsame Abdeckhaube zugeordnet ist, die derart ausgebildete Innenkonturen aufweist, daß mit dem Aufpressen der Abdeckhaube alle in Klemmbereiche verlegten Drähte in die entsprechenden Schneidklemmbreiche eingedrückt werden.

Eine vorteilhafte Weiterbildung der Erfindung dient der möglichst zugspannungsfreien Verlegung der Drähte in den zwischen den Schneidklemmen gebildeten Gassen und sieht in diesem Zusammenhang vor, daß die Drähte innerhalb des Verdrahtungswerkzeugs mit einer zumindest annähernd der Verlegegeschwindigkeit des Verdrahtungswerkzeugs entsprechenden Geschwindigkeit antreibbar sind. Nach Festlegen eines Drahtes im Klemmbereich einer Schneidklemme erfolgt also die weitere Verlegung spannungslos, d. h. daß keine Zugkräfte auf den Leiter ausgeübt werden. Bei Vorhandensein einer größeren Anzahl von in den Verlegegassen verlegten Drähten wird damit vermieden, daß während der nachfolgenden Verlegephasen ungewollt Drähte aus den Klemmbereichen von Schneidklemmen herausgedrückt oder herausgezogen werden. Ein wesentlicher Vorteil der zugspannungslosen Verlegung der Drähte in den Verlegegassen besteht darin, daß an den durch die Außenkonturen der Schneidklemmen gebildeten Umlenkbereichen für die Drähte keine Kerbwirkung auf diese ausgeübt wird; Beschädigungen der Isolation und dadurch bedingte Fehlkontaktierungen sind somit vermieden.

Ebenfalls dem störungsfreien Verlegen der Leiter zwischen den Schneidklemmen dient eine spezielle Ausbildung eines Verdrahtungsfeldes, das im Rahmen des erfindungsgemäßen Verfahrens verwendet werden kann. Es wird vorgesehen, daß die Schneidklemmen in ihrem dem Verdrahtungswerkzeug zugewandten Endbereich seitliche Überstände aufweisen, die die zwischen den Schneidklemmen gebildeten Verlegegassen teilweise überdecken. Ein ungewolltes Austreten von bereits verlegten Drähten während der Weiterführung . des Verlegevorgangs kann damit insbesondere bei außermittiger Verlegung der Drähte innerhalb der Verlegegassen vermieden werden. Aufgrund der durch die gassenparallele Verfahrbewegung des Verdrahtungswerkzeugs bedingten bogenförmigen Verlaufs des verlegten Drahtes ist diesem die Neigung immanent, nach oben aus der Verlegegasse auszutreten, wobei dieser Effekt quantitativ mit dem Durchmesser des Drahtes und der Verlegevorgänge innerhalb einer Verlegegasse zunimmt. Diesem Effekt kann dadurch entgegengewirkt werden, daß die Schneidklemmen derart ausgebildet und/oder angeordnet sind, daß entlang der jeweils zwischen zwei Reihen von Schneidklemmen gebildeten Verlegegassen die Überstände der Schneidklemmen der beiden Reihen alternierend in die Verlegegasse hineinragen.

Eine besonders geglückte Kombination zwischen einerseits leichtem Zugang für das Verdrahtungswerkzeug zur Verlegung der Drähte innerhalb der zwischen den Schneidklemmen gebildeten Verlegegassen und andererseits der Sicherheit gegen unbeabsichtigtes Herausdrücken von verlegten Drähten aus den Verlegegassen stellt eine vorteilhafte Weiterbildung der Erfindung dar, gemäß der die Überstände der Schneidklemmen zweier eine Verlegegasse einschließenden Reihen von Schneidklemmen entlang der Verlegegasse zumindest bis an eine gassenparallele Verlegelinie, äußerstenfalls um eine dem Durchmesser des verlegten Drahtes entsprechende Strecke darüber hinausragen. Der in der Ebene der Überstände annähernd vertikal in die Verlegegasse eintretende Draht weicht dabei an den Randbereichen der Überstände - die vorzugsweise abgerundet sind -jeweils aus und 'schlängelt' sich somit in die Verlegegasse ein; der nach der Verlegung bogenförmig in der Verlegegasse liegende Draht kann aber nicht mehr -an allen Randbereichen der die Verlegegasse überdachenden Überstände vorbei -aus der Verlegegasse austreten.

Die Erfindung wird im folgenden anhand eines in drei Figuren dargestellten Ausführungsbeispiels erläutert. Die Figur 1 zeigt in einer vergrößerten Darstellung eine Schneidklemme mit einem Draht in der Phase vor dem und nach dem Eindrücken in den eigentlichen Schneidklemmbereich. In der Figur 2 ist ein Ausschnitt aus einem Verdrahtungsfeld mit mehreren bereits verlegten aber noch nicht in den Schneidklemmbereich der Schneidklemmen eingedrückten Drähten dargestellt. Die Figur 3 zeigt in einer schematischen Darstellung den Auslaufbereich eines Verdrahtungswerkzeugs zum Verlegen von Drähten innerhalb des Verdrahtungsfeldes.

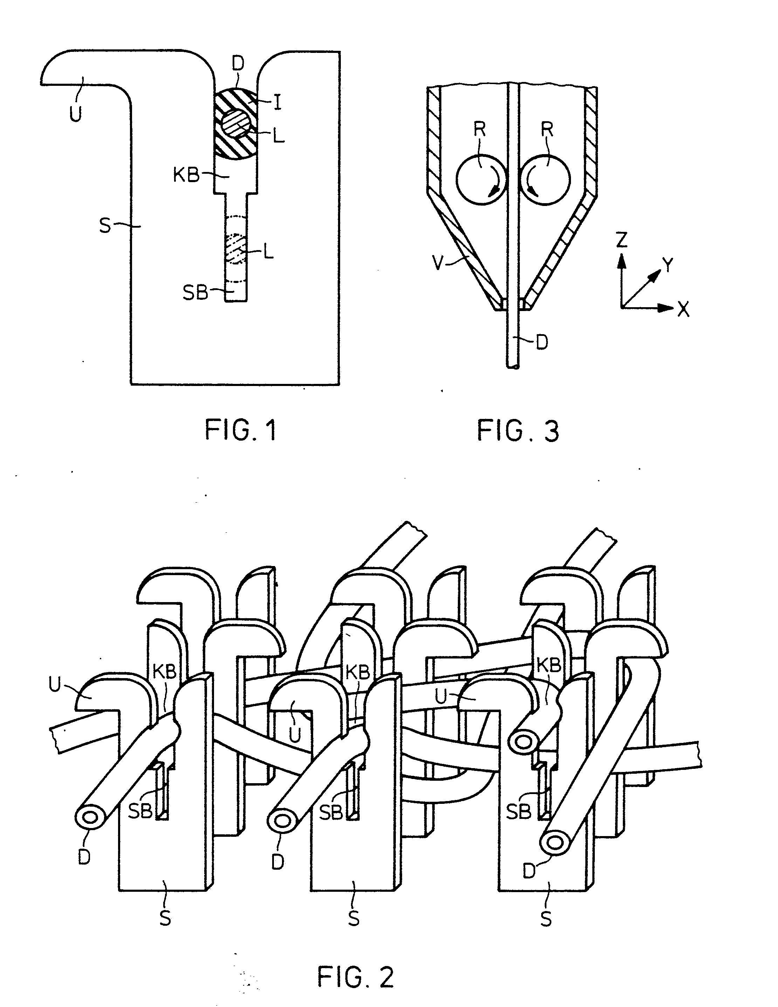

Die in der Figur 1 dargestellte Schneidklemme S weist einen zentralen Schlitz auf, der durch einen an einen Einführungsbereich EB anschließenden Klemmbereich KB und einen daran anschließenden Schneidklemmbereich SB gebildet ist. Die lichte Weite des Klemmbereiches KB ist größer als der Durchmesser eines Leiters L und kleiner als der Durchmesser einer Isolation I eines zu verlegenden Drahtes D bemessen. Die lichte Weite des Schneidklemmbereiches SB ist dagegen kleiner als der Durchmesser des Leiters L bemessen. Die Schneidklemme S weist in ihrem oberen Bereich einen seitlichen Überstand U auf, der eine zwischen mehreren hintereinander liegenden Schneidklemmen gebildete Verlegegasse abdeckt.

Der in der Figur 2 dargestellte Ausschnitt eines Verdrahtungsfeldes beinhaltet mehrere Schneidklemmen S, die sowohl nebeneinander als auch hintereinander angeordnet sind. Nebeneinander liegende Schneidklemmen S weisen dabei Überstände U auf, die jeweils in die gleiche Richtung zeigen, während die jeweils in der dahinter liegenden parallelen Reihe gelegenen Schneidklemmen S zwar ebenfalls nur einen seitlichen Überstand aufweisen, diese jedoch in die entgegengesetzte Richtung weist. Die Überstände U überlappen sich dabei um eine etwas geringer als der Drahtdurchmesser bemessene Strecke. Damit werden einerseits gut zugängliche, andererseits aber gut gegen das Heraustreten von Drähten D geschützte Verlegegassen gebildet. In der dargestellten Verlegephase sind bereits mehrere Drähte D so verlegt, daß die Drähte innerhalb des Klemmbereiches KB liegen. In einem nachfolgenden Fertigungsschritt werden alle Drähte D gleichzeitig aus dem Klemmbereich KB in den Schneidklemmbereich SB eingedrückt.

Der in der Figur 3 dargestellte untere Bereich eines Verdrahtungswerkzeugs V zum Verlegen von Drähten D innerhalb eines Verdrahtungsfeldes gemäß Figur 2 weist drei Freiheitsgrade der Bewegung (x, y, z) auf; das Verdrahtungswerkzeug V kann damit beliebig in die Verlegegassen zwischen den Schneidklemmen einfahren. Durch zwei angetriebene Reibrollen R ist angedeutet, daß der Draht D aus dem Verdrahtungswerkzeug V herausgefördert werden kann; damit ist eine zugspannungsfreie Verlegung des Drahtes D innerhalb der Verlegegassen des Verdrahtungsfeldes möglich.

## Ansprüche

1. Verfahren zur Verlegung von Drähten in einem Verdrahtungsfeld mit galvanisch mit Anschlußpunkten elektrischer Schaltungsanordnungen verbundenen Anschlußelementen zum lötfreien Anschluß der beliebige Anschlußelemente miteinander verbindenden Drähte mittels eines Verdrahtungswerkzeugs , **dadurch gekennzeichnet,** daß die Anschlußelemente als Schneidklemmen (S) mit einen sich an einen Einführungsbereich anschließenden Klemmbereich - (KB) ausgebildet sind, in dem die als Leiter(L) mit Isolation - (I) ausgebildeten Drähte (D) zunächst klemmend festgelegt werden, und einem an den Klemmbereich (KB) anschließenden Schneidklemmbereich (SB), in den die Drähte (D) nach beendeter Verlegung eingedrückt werden.

2. Verfahren nach Anspruch 1 , **dadurch gekennzeichnet,** daß die Drähte (D) innerhalb des Verdrahtungswerkzeugs (V) mit einer zumindest annähernd der Verlegegeschwindigkeit des Verdrahtungswerkzeugs (V) entsprechenden Geschwindigkeit antreibbar sind.

3. Verfahren nach Anspruch 1 oder 2 , **dadurch gekennzeichnet,** daß die Drähte (D) mittels des Verdrahtungswerkzeugs (V) sukzessiv in die Schneidklemmbereiche - (SK) eingedrückt werden.

4. Verfahren nach Anspruch 3 , **dadurch gekennzeichnet,** daß die Drähte (D) in derselben Reihenfolge in die Schneidklemmbereiche (SB) eingedrückt werden, in der sie in die Klemmbereiche (KB) verlegt sind.

5. Verfahren nach Anspruch 1 oder 2 , **dadurch gekennzeichnet** , daß die Drähte (D) mittels eines zumindest eine Vielzahl von Schneidklemmen (S) gleichzeitig erfassenden Werkzeugs in die Schneidklemmbereiche (SB) eingedrückt werden.

6. Verdrahtungsfeld zur Durchführung des Verfahrens nach Anspruch 1 oder 2 , **dadurch gekennzeichnet,** daß allen Schneidklemmen (S) eine gemeinsame Abdeckhaube zugeordnet ist, die derart ausgebildete Innenkonturen aufweist, daß mit dem Aufpressen der Abdeckhaube alle im Klemmbereich (KB) verlegten Drähte (D) in die entsprechenden Schneidklemmbereiche (SB) eingedrückt werden.

7. Verdrahtungsfeld zur Durchführung des Verfahrens nach einem der Ansprüche 1 bis 5 , **dadurch gekennzeichnet,** daß die Schneidklemmen (S) in ihrem dem Verdrahtungswerkzeug zugewandten Endbereich seitliche Überstände - (U) aufweisen, die die zwischen den Schneidklemmen (S) gebildeten Verlegegassen teilweise überdecken.

8. Verdrahtungsfeld nach Anspruch 7 , **dadurch gekennzeichnet,** daß die Schneidklemmen (S) derart ausgebildet und/oder angeordnet sind, daß entlang der jeweils zwischen zwei Reihen von Schneidklemmen (S) gebildeten Verlegegassen die Überstände (U) der Schneidklemmen (S) der beiden Reihen alternierend in die Verlegegasse hineinragen.

9. Verdrahtungsfeld nach Anspruch 8 , **dadurch gekennzeichnet,** daß die Überstände (U) der Schneidklemmen - (S) zweier eine Verlegegasse einschließenden Reihen von Schneidklemmen (S) entlang der Verlegegasse zumindest bis an eine gassenparallele Verlegelinie, äußerstenfalls um eine dem Durchmesser des verlegten Drahtes (D) entsprechende Strecke darüber hinausragen.

85 P 4014

FIG. 1

FIG. 3

FIG. 2

Europäisches
Patentamt

**EUROPÄISCHER RECHERCHENBERICHT**

Nummer der Anmeldung

EP 86 73 0023

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 044 636 (AMP) <br> * Seite 8, Zeilen 2-17; Figur 8 * | 1,5 | H 01 R 43/01 <br> H 01 R 4/24 <br> H 05 K 13/06 |
| A | EP-A-0 109 735 (AMP) <br> * Seite 1, Zusammenfassung; Figuren 2,3 * | 1,3 | |
| A | US-A-4 129 349 (BELL TELEPHONE) <br> * Seite 1, Zusammenfassung; Figuren 2,9,10 * | 1 | |
| A | GB-A-2 026 256 (YAMAICHI) <br> * Seite 2, Zeile 120 - Seite 3, Zeile 4; Figuren 1,3 * | 1,6 | |
| A | FR-A-2 232 848 (RELIABLE ELECTRIC CO.) <br> * Figuren 1-4 * | 1,6 | RECHERCHIERTE SACHGEBIETE (Int. Cl.4) |
| A | DE-A-2 031 729 (SIEMENS) <br> * Seite 3, Absatz 2 - Seite 4, Absatz 1 * | 1,2 | H 01 R <br> H 05 K |

Der vorliegende Recherchenbericht wurde für alle Patentansprüche erstellt.

| Recherchenort <br> DEN HAAG | Abschlußdatum der Recherche <br> 23-05-1986 | Prüfer <br> LOMMEL A. |
|---|---|---|